(19) Europäisches Patentamt / European Patent Office / Office européen des brevets

(11) **EP 4 703 453 A1**

(12) **EUROPEAN PATENT APPLICATION**
published in accordance with Art. 153(4) EPC

(43) Date of publication:
**04.03.2026 Bulletin 2026/10**

(51) International Patent Classification (IPC):
**C09K 11/80** (2006.01)     **C09K 11/00** (2006.01)
**C09K 11/08** (2006.01)     **G01T 1/20** (2006.01)

(21) Application number: **24796996.7**

(52) Cooperative Patent Classification (CPC):
**C09K 11/00; C09K 11/08; C09K 11/77; G01T 1/20**

(22) Date of filing: **23.04.2024**

(86) International application number:
**PCT/JP2024/015835**

(87) International publication number:
**WO 2024/225250 (31.10.2024 Gazette 2024/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.04.2023 JP 2023071301**

(71) Applicant: **Niterra Materials Co., Ltd.**
**Yokohama-shi, Kanagawa 235-0032 (JP)**

(72) Inventors:
• **USUI, Daichi**
  **Yokohama-shi, Kanagawa 235-0032 (JP)**
• **TAGUCHI, Seina**
  **Yokohama-shi, Kanagawa 235-0032 (JP)**

(74) Representative: **Hoffmann Eitle**
**Patent- und Rechtsanwälte PartmbB**
**Arabellastraße 30**
**81925 München (DE)**

(54) **CERAMIC SCINTILLATOR, PHOTON COUNTING-TYPE X-RAY DETECTOR, AND METHOD FOR PRODUCING CERAMIC SCINTILLATOR**

(57) A ceramic scintillator according to an embodiment includes a garnet compound having a composition represented by $(Lu_{1-x}Pr_x)_a(Al_{1-y-z}Ga_yM_z)_bO_{1.5\{a+b\}}$, In the ceramic scintillator, M in the composition includes one kind or more of Si, Ge, and Sn, and x, y, and z respectively satisfy $0.002 \leq x \leq 0.500$, $0.1 \leq y \leq 0.8$, and $0.0010 \leq z \leq 0.1000$.

FIG. 2

EP 4 703 453 A1

**Description**

## TECHNICAL FIELD

An embodiment of the preset invention relates to a ceramic scintillator, a photon-counting type X-ray detector, and a method for producing the ceramic scintillator.

## BACKGROUND ART

Imaging systems using radiation, for example, X-rays are widely used in industrial applications such as baggage inspection and nondestructive inspection, and in medical applications such as X-ray diagnostic equipment and X-ray CT (Computed Tomography) equipment. Current mainstream detection methods in imaging systems using X-rays are of an energy integration type, and generally have a configuration in which a light-emitting material and a photodetector are combined.

However, the energy integration type has problems that X-ray energy information cannot be obtained and that the exposure dose is large. In recent years, in order to solve these problems, development of X-ray detectors employing a photon-counting method has been advanced. Photon-counting type X-ray detectors are also called photon detectors or photon-counting type detectors.

The photon-counting method is characterized in that pulse signal processing is performed for incident X-ray photons one by one. Photon-counting methods are classified into a direct type that uses a semiconductor such as CdTe to convert X-rays directly into electrical signals, and an indirect type that converts X-rays into light with a light-emitting material and converts the light into electrical signals using a photodetector.

Among the photon counting methods, the direct type can measure X-ray photon energy from the number of carriers, the indirect type can measure the X-ray photon energy from the number of emission photons, and since it is easy to remove noise components, data with a high S/N ratio can be obtained. Due to these advantages, realization of new functional diagnoses and reduction of exposure dose due to low dose measurement are expected in medical applications. The mainstream of research and development in the photon-counting method is the direct type that can obtain high energy resolution. However, the problems of the direct type are high cost of semiconductor materials such as CdTe, difficulty of manufacturing large-area detectors due to difficulty of obtaining uniform characteristics, and signal pile-up phenomenon due to slow response speed of the materials.

On the other hand, in the photodetectors of the indirect type among the photon-counting methods, photoelectron multiplier tubes having high multiplication factors are generally used. However, the indirect type has problems that the shape of the photoelectron multiplier tube is large and that pixel configuration with a narrow gap is difficult. A silicon photomultiplier (Si-PM) that is a Si-based photodetector that operates in the Geiger mode, and has recently been developed solves the problems of the photoelectron multiplier tube described above, has a multiplication factor close to that of photoelectron multiplier tubes, and is low cost. Therefore, in the indirect type, it is expected that the use of silicon photomultipliers will expand in the future.

### PRIOR ART DOCUMENTS

### PATENT DOCUMENT

Patent Document 1: Japanese Patent Laid-Open No. 2018-2974
Patent Document 2: Japanese Patent Laid-Open No. 2010-235388

### SUMMARY OF THE INVENTION

### PROBLEMS TO BE SOLVED BY THE INVENTION

A common technical problem for both the direct type and the indirect type is that they cannot handle high counting rates. A counting rate indicates the number of X-ray photons incident on a unit area at a unit time, and corresponds to the intensity of the X-rays.

When performing a large amount of imaging by photocounting X-ray measurement in a short period of time, a detector that handles a high counting rate is required. Such a situation is necessary for X-ray CT, and the required counting rate at this time is said to be $10^8$ [cps/mm$^2$] or more. This is equivalent to the X-ray photons being incident on an area of 1 [mm$^2$] at an average interval of 10 [nsec]. When the counting rate exceeds the capacity of the detector, overlapping of the pulse signals occurs, and it becomes difficult to measure the correct X-ray photon energy.

On the other hand, long-term measurement with a suppressed counting rate increases the imaging time, and causes problems such as reduction in throughput and reduction in time resolution. The counting rate that can be handled by the detector is mainly determined by the response speed of the materials, and therefore improvement is expected.

The problem to be solved by the present invention is to provide a ceramic scintillator that can handle with a high counting rate, a photon-counting type X-ray detector, and a method for manufacturing the ceramic scintillator.

## MEANS FOR SOLVING THE PROBLEMS

A ceramic scintillator according to an embodiment includes a garnet compound having a composition represented by $(Lu_{1-x}Pr_x)_a(Al_{1-y-z}Ga_yM_z)_bO_{1.5\{a+b\}}$, In the ceramic scintillator, M in the composition includes one kind or more of Si, Ge, and Sn, and x, y, and z respectively satisfy $0.002 \leq x \leq 0.500$, $0.1 \leq y \leq 0.8$, and $0.0010 \leq z \leq 0.1000$.

## BRIEF DESCRIPTION OF THE DRAWINGS

[FIG. 1] FIG. 1 is a schematic view illustrating a configuration of a photon-counting type X-ray detector according to an embodiment.

[FIG. 2] FIG. 2 is an enlarged sectional view of a partial region shown in a division (B) of FIG. 1 in the photon counting type X-ray detector according to the embodiment.

[FIG. 3] FIG. 3 is a table showing changes in a light yield and a decay time constant according to variables x, y, and z in the composition, in comparative examples.

[FIG. 4] FIG. 4 is a table showing changes in the light yield and decay time constant according to the variables x, y, and z in the composition, in examples and comparative examples.

[FIG. 5] FIG. 5 is a table showing changes in the light yield and decay time constant according to the variables x, y, and z in the composition, in examples and comparative examples.

[FIG. 6] FIG. 6 is a table showing changes in the light yield and decay time constant according to the variables x, y, and z in the composition, in examples and comparative examples.

[FIG. 7] FIG. 7 is a table showing changes in the light yield and decay time constant according to the variables x, y, and z in the composition, in examples and comparative examples.

[FIG. 8] FIG. 8 is a table showing changes in the light yield and decay time constant according to the variables x, y, and z in the composition, in comparative examples.

[FIG. 9] FIG. 9 is a table showing changes in the light yield and decay time constant according to a variable a/b in the composition, in comparative examples.

[FIG. 10] FIG. 10 is a table showing changes in the light yield and decay time constant according to the variable a/b in the composition, in examples and comparative examples.

[FIG. 11] FIG. 11 is a table showing changes in the light yield and decay time constant according to the variable a/b in the composition, in examples and comparative examples.

[FIG. 12] FIG. 12 is a table showing changes in the light yield and decay time constant according to the variable a/b in the composition, in examples and comparative examples.

[FIG. 13] FIG. 13 is a table showing changes in the light yield and decay time constant according to the variable a/b in the composition, in comparative examples.

## DESCRIPTION OF EMBODIMENTS

Hereinafter, embodiments of a ceramic scintillator, a photon-counting type X-ray detector, and a method for manufacturing the ceramic scintillator will be described in detail with reference to the drawings.

(Photon-counting Type X-ray Detector)

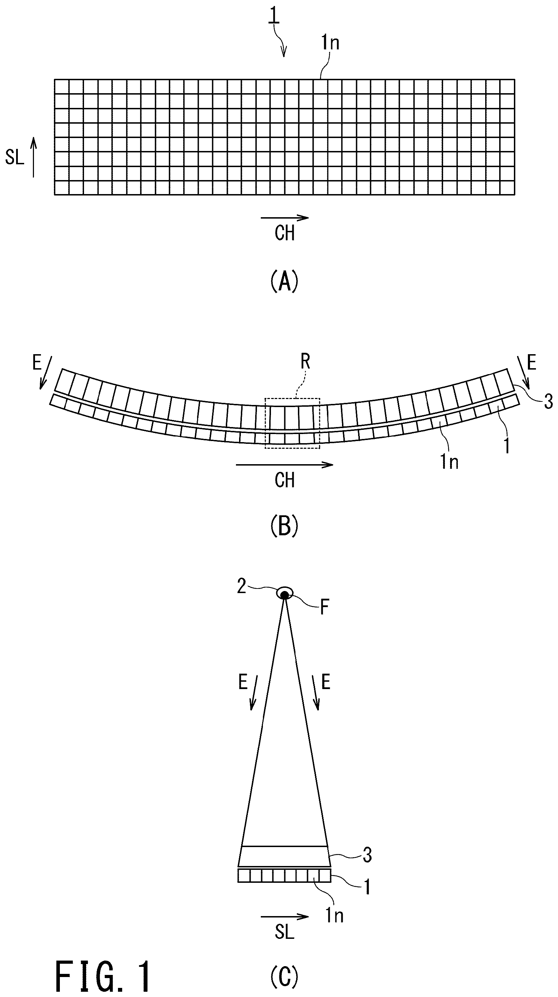

Each of divisions (A) to (C) of FIG. 1 is a schematic view illustrating a configuration of a photon-counting type X-ray detector according to an embodiment. The division (A) of FIG. 1 is a top view of the photon-counting type X-ray detector according to the embodiment. The division (B) of FIG. 1 is a side view illustrating a channel direction CH of the photon-counting type X-ray detector according to the embodiment. The division (C) of FIG. 1 is a side view illustrating a slice direction SL of the photon-counting type X-ray detector according to the embodiment.

Each of the divisions (A) to (C) of FIG. 1 illustrates a photon-counting type X-ray detector (hereinafter, simply referred to as an "X-ray detector") 1 according to the embodiment. Each of the divisions (B) and (C) of FIG. 1 illustrates a collimator device 3 in addition to the X-ray detector 1. The division (C) of FIG. 1 illustrates an X-ray tube 2 in addition to the X-ray detector 1.

The X-ray detector 1 is installed on a rotating frame of a holding device. The X-ray detector 1 is provided with n (n: a plurality) of X-ray detection elements 1n. The X-ray detection elements 1n are arranged two-dimensionally in a matrix form in the channel direction and the slice direction SL. The channel direction means a spread direction of fan beam X-rays emitted from the X-ray tube 2, and the slice direction means a thickness direction of the fan beam X-rays.

An X-ray incident surface of the X-ray detector 1 is formed by X-ray incident surfaces of the X-ray detection elements 1n. For example, about 1000 X-ray detection elements 1n are arranged in the channel direction CH, and 64 X-ray detection elements 1n are arranged in the slice direction SL.

The X-ray tube 2 is installed in a rotating frame of a holding device to face the X-ray detector 1. The X-ray tube 2 is a vacuum tube that generates X-rays by irradiating thermal electrons from a cathode (filament) to an anode (target) by applying a high voltage. For example, among X-ray tubes 2, there is a rotating anode type X-ray tube that generates X-rays by irradiating a rotating anode with thermal electrons.

A collimator device 3 has a plurality of collimator plates having a function of absorbing scattered X-rays. The plurality of collimator plates comprise plates that extend in the slice direction SL and are provided to be erected to divide the X-ray detection elements 1n in the channel direction CH (one-dimensional collimator). Alternatively, the plurality of collimator plates comprise plates that extend in the slice direction SL and are provided to be erected to divide the X-ray detection elements 1n in the channel direction CH, and plates that extend in the channel direction CH and are provided to be erected to divide the X-ray detection elements 1n in the slice direction SL (two-dimensional collimator). An inclination of the plate surface of the collimator plate is adjusted to be parallel to an X-ray irradiation direction E that is a direction in which X-rays from an X-ray focal point F of the X-ray tube 2 are irradiated. The division (C) of FIG. 1 illustrates a case in which the collimator device 3 is a one-dimensional collimator. What is made by combining the collimator device 3 with the X-ray detector 1 is sometimes called a "photon-counting type X-ray detector".

The X-ray detector 1 may be configured by arrangement of a plurality of detector modules by modularizing a predetermined number of X-ray detection elements among the X-ray detection elements 1n. Likewise, the collimator device 3 may be configured by arrangement of a plurality of collimator modules by modularizing a predetermined number of collimator plates.

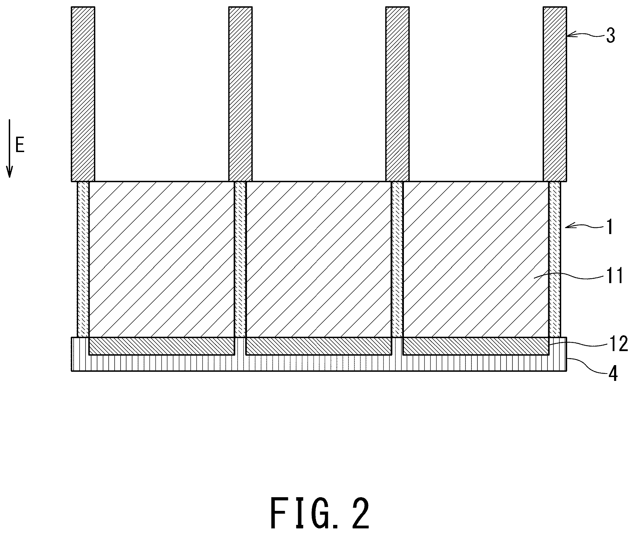

FIG. 2 is an enlarged sectional view of a partial region R illustrated in the division (B) of FIG. 1 in the X-ray detector 1.

The X-ray detection elements 1n are provided on a ceramic substrate 4. Each of the X-ray detection elements 1n includes a ceramic scintillator 11 and a photoelectric conversion element 12.

The ceramic scintillator 11 is an element that converts incident X-rays into photons and emits the photons. Here, X-rays usually have a predetermined X-ray energy distribution. An X-ray having a specific X-ray energy can be considered a mass of X-ray particles a number of which corresponds to a magnitude of the X-ray energy. The ceramic scintillator 11 converts the X-ray particles into photons with a predetermined probability while maintaining a mass of the X-ray particles. When X-rays are incident on the ceramic scintillator 11, the ceramic scintillator 11 emits substantially simultaneously photon groups in number corresponding to the X-ray energy according to X-ray energy.

The ceramic scintillator 11 is a light conversion element having a substantially rectangular parallelepiped or cubic shape. The ceramic scintillator 11 is disposed so that an X-ray incident surface thereof is substantially perpendicular to an X-ray irradiation direction, that is, the X-ray incident direction E, and a side surface parallel to the X-ray incident direction E is substantially parallel to the channel direction CH and the slice direction SL.

The photoelectric conversion element 12 has a substantially plate-shaped rectangular parallelepiped shape, converts incident photons into electrical signals, and outputs the electrical signals. The electrical signals are electrical pulse signals corresponding to the individual incident photons. When photon groups are simultaneously incident on the photoelectric conversion element 12, the photoelectric conversion element 12 outputs a pulse signal a wave height of which corresponds to a number of photons configuring the photon group. The photoelectric conversion element 12 is a semiconductor device suitable for so-called photon counting, and is, for example, a silicon photomultiplier (Si-PM). A silicon photomultiplier is a high-performance semiconductor photon detector that is capable of photon counting (photon counting) measurement, and is also applicable to analogue measurement such as scintillation detection. A silicon photomultiplier is an element in which a large number of pixels of avalanche photodiodes (APD) that operate in the Geiger mode are connected in parallel.

The photoelectric conversion element 12 receives photons emitted from the ceramic scintillator 11, and outputs electrical signals in a pulse form. When intensity of transmission X-rays of an object is sufficiently low, the photon groups according to X-ray energy are released in a scattered state in a time axis direction, in the ceramic scintillator 11. At this time, the photoelectric conversion element 12 outputs, for each X-ray energy, a pulse signal having a wave height corresponding to the magnitude of the X-ray energy in numbers corresponding to a dose of the X-rays having the X-ray energy, in a state dispersed in the time axis direction. Accordingly, if the pulse signals outputted in a fixed time are counted for each wave height, it is possible to know a dose of transmission X-rays of the object for each X-ray energy. If all the pulse signals outputted in a fixed time are counted regardless of wave heights, it is possible to know a dose of all transmission X-rays of the object.

To the photoelectric conversion element 12, conductor patterns (not illustrated) formed on the ceramic substrate 4 are respectively connected. The electrical signals from the photoelectric conversion element 12 are outputted to an external processing device (not illustrated) through these conductor patterns. The electrical signals outputted from the photoelectric conversion element 12 are used in collection of projection data by a photon-counting method.

Here, a detector used in the photon-counting method generally has a very high X-ray detection sensitivity. The detector has high sensitivity, that is, can obtain signals with sufficient S/N, even if the dose of X-rays is low, and a number of photons emitted from the scintillator is small. However, when the dose of X-rays is large, the pulse signals are superimposed, a phenomenon called pile-up (pile up) occurs, and it becomes impossible to resolve the signals in the time axis direction.

Among the photon counting methods, in the case of the indirect type, there is a problem of counting rate as in the case of the direct type. The counting rate indicates the number of incident X-ray photons per unit area per unit time. In order to realize imaging by a photon-counting type X-ray detector, a detector handling with a high counting rate is necessary. For example, a counting rate required in X-ray CT equipment is $10^8$ [cps/mm$^2$] or more. This means that X-ray photons are incident on an area of 1 [mm$^2$] at an average interval of 10 [nsec]. At present, a scintillator capable of handling with such a high counting rate has not been put into practical use. If the counting rate exceeds a capacity of the scintillator, pile-up occurs, and it becomes difficult to measure correct photon energy. On the other hand, suppressing the counting rate and performing measurement for a long time causes problems such as a decrease in throughput and a decrease in time resolution.

The counting rate of a scintillator is mainly determined by a response speed of the material. Therefore, there is an urgent need to develop materials for scintillators with improved response speeds so as not to cause pile-up while avoiding long-time measurements.

(Ceramic Scintillator and Manufacturing Method Thereof)

A main factor that determines the response speed of the indirect type is a decay time constant of light emission of a scintillator. In order to realize the aforementioned counting rate $10^8$ [cps/mm$^2$], control of the decay time constant of light emission of the scintillator becomes particularly important, and it is preferable that the decay time constant of light emission is about 17 [nsec] or less. By making the decay time constant of light emission 17 [nsec] or less, it becomes possible to prevent pile-up and realize imaging at a practical level as described above. Thus, experiments were conducted with an aim of setting the decay time constant of light emission of the scintillator to about 17 [nsec] or less. As a result, it was found that a light yield of 10000 [ph/MeV] or more is good. This is because if the light yield is 10000 [ph/MeV] or more, there is no problem in both the S/N ratio and the energy resolution, and a detector with higher accuracy can be obtained.

In other words, it is desirable that the decay time constant is 17 [nsec] or less and the light yield is 10000 [ph/MeV] or more. For this purpose, a fluorescent material of the ceramic scintillator 11 that is applied as the light conversion element is a garnet compound having a composition represented by

$$(Lu_{1-x}Pr_x)_a(Al_{1-y-z}Ga_yM_z)_bO_{1.5(a+b)},$$

wherein M in the composition includes one kind or more of Si, Ge, and Sn, and x, y, and z respectively satisfy all of

$$\text{Condition 1: } 0.002 \leq x \leq 0.500,$$

$$\text{Condition 2: } 0.1 \leq y \leq 0.8$$

and

$$\text{Condition 3: } 0.0010 \leq z \leq 0.1000.$$

Here, the decay time constant is defined as a time it takes for the light emission intensity to decrease to 1/e (=0.3679) of a maximum light emission intensity when a time at which a light emission intensity generated by radiating radiation of a short-time pulse becomes maximum is zero. For example, a change with time of the light emission intensity is recorded by performing time-correlated signal photon counting method (Time-Correlated Single Photon Counting: TCSPC) using a pulsed X-ray tube, and the decay time constant can be calculated from a numeric value thereof.

Furthermore, in the garnet compound having the above-described composition, it is more desirable to include the following condition.

Condition 4: $0.50 \leq a/b \leq 0.70$

A coefficient of O in the composition is 1.5 times a sum of a and b, and therefore, if a=3, and b=5, the coefficient is 12.

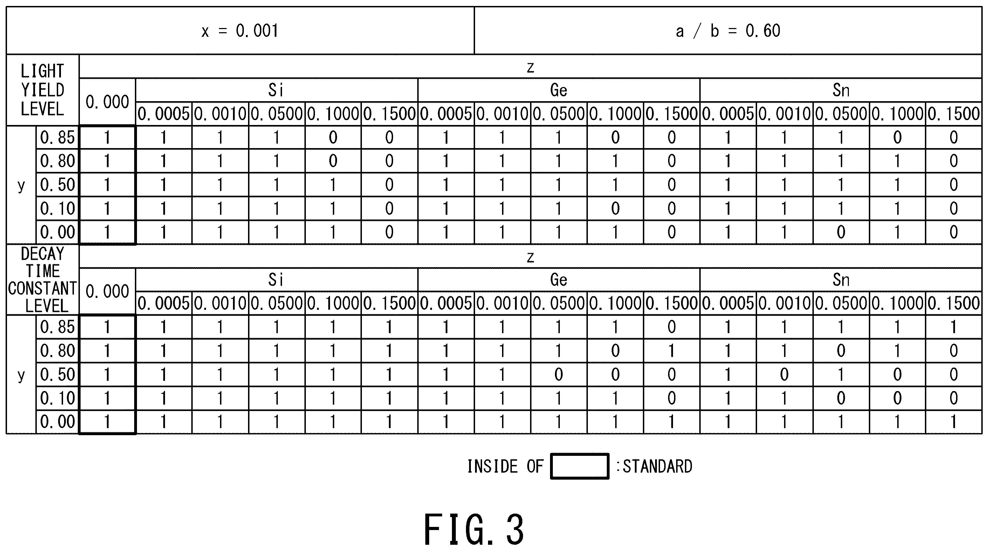

As described above, in the aforementioned composition, M includes one kind or more of tetravalent elements Si, Ge, and Sn. Among light emission elements Pr, $Pr^{3+}$ emits light, and $Pr^{4+}$ does not emit light and absorbs visible light. Therefore, presence of $Pr^{4+}$ is a factor of reducing the characteristics of the light yield and the decay time constant of the scintillator. Since Pr replaces $Lu^{3+}$, most of it is $Pr^{3+}$, but there is a problem that traces of $Pr^{4+}$ remain. Here, if a divalent element is added, Pr tends to become tetravalent in order to maintain the charge balance, and therefore the characteristics of the light yield and the decay time constant of the scintillator are further reduced. On the other hand, if a tetravalent element is added, Pr tends to become trivalent in order to maintain the charge balance, and therefore, it is possible to stabilize $Pr^{3+}$ by suppressing residual $Pr^{4+}$ and improve the characteristics. A degree of addition of the tetravalent element is determined as the above-described conditions 1 to 4 based on the characteristics of the light yield and decay time constant which will be described later by using FIGS. 3 to 13.

Subsequently, results of producing fluorescent materials according to examples having the compositions that satisfy the above-described conditions 1 to 4, and fluorescent materials according to comparative examples that do not satisfy at least one of the above-described conditions 1 to 4, and investigating the characteristics of the light yield and the decay time constant of light emission will be described. The fluorescent materials according to the examples, and the fluorescent materials according to the comparative examples are produced through the following steps.

First, in a first step, a powder of a mixture (mixture of powders of oxides of Lu, Pr, Al, Ga, and M) of lutetium oxide, praseodymium oxide, alumina, gallium oxide, and an oxide of a tetravalent element M (for example, Si, Ge, Sn) is filled into an alumina container and mixed. In a second step, the mixed powder is fired at a temperature of 1300[°C] or higher. In a third step, the product obtained by the second step is filled into an alumina container and fired at a temperature of 1200[°C] or higher in a nitrogen/hydrogen mixed atmosphere. In a fourth step, the product obtained by the third step is molded. In a fifth step, a ceramic scintillator is manufactured by sintering the product obtained by the fourth step.

Sintering is done in one step. By performing sintering in one step, unlike the case of performing sintering in two steps or more, it is possible to obtain a ceramic scintillator that has little deviation in composition and good crystallinity, and has a small decay time constant because it can suppress volatilization of Ga.

The fluorescent materials comprise elements contained in the above-described composition, and do not contain any other elements except for unavoidable impurities. This is because the decay time constant of light emission changes depending on the contained elements, and therefore when a large amount of impurities is contained, the decay time constant of light emission may increase. Impurities of 100 ppm or more may be included as long as they comply with the required light yield and/or the required decay time constant of light emission. Here, when Si functions as a sintering aid, it remains as an impurity in grain boundaries of the ceramic scintillator as a finished product. Therefore, when Si remains in the grain boundaries, it can be determined that Si is added as a sintering aid, and when Si is present in a base material, it can be determined that it is added as a raw material. In the ceramic scintillator according to the embodiment, Si, Ge, and Sn compounds are not present in the grain boundaries except when several tens ppm of them are present as impurities, which means a garnet compound containing Si, Ge, or Sn in the base material.

(The Above-described Conditions 1 to 3, That Is, Variables x, y, z)

Changes in the light yield and decay time constant according to a type of a metal M and variables x, y, and z in the composition of $(Lu_{1-x}Pr_x)_a(Al_{1-y-z}Ga_yM_z)_bO_{1.5(a+b)}$ will be described by using FIG. 3 to FIG. 8.

FIG. 3 will be described. FIG. 3 shows levels of a light yield when x in the composition is "0.001" which is outside of the range of the above-described condition 1, and a/b is "0.60" which is within the range of the above-described condition 4 (upper row), and levels of a decay time constant in the same case (lower row). That is to say, FIG. 3 shows the levels of the light yield in the case of comparative examples (all of 80 in the upper row), and the levels of the decay time constant in the case of the comparative examples (all of 80 in the lower row). Furthermore, the metal M related to the variable z is any one of Si, Ge, and Sn.

With x fixed to 0.001, and a/b to 0.60, y and z of the above-described conditions 2 and 3 are used as variables to find the light yields [ph/MeV] and the decay time constants [nsec]. Then, the ratios [%] of the light yields [ph/MeV] when z≈0.000 (for example, z=0.0005, 0.0010, 0.0500, 0.1000, and 0.1500), to the light yield [ph/MeV] when z=0.000 which is the standard, are obtained, and the ratios are classified into levels "0" to "3" in order from a lowest value to create the upper row in FIG. 3 (see Table 1). In the cases in which x, y, and a/b have the same values, the light yields at z=0.0005, 0.0010, 0.050, 0.1000, and 0.150, relative to the light yield at z=0 (within the thick solid line rectangle shown in the upper row of FIG. 3) are respectively classified into four levels.

[Table 1]

| Ratio [%] of Light Yield to That of Standard | Level |
|---|---|
| Ratio of Light Yield < 95 | 0 |
| 95 ≤ Ratio of Light Yield < 105 | 1 |
| 105 ≤ Ratio of Light Yield < 125 | 2 |
| 125 ≤ Ratio of Light Yield | 3 |

On the other hand, the ratios [%] of the decay time constants [nsec] when z≈0.000, to the decay time constant [nsec] when z=0.000 which is the standard, are obtained, and the ratios are classified into levels "0" to "3" in order from a highest value to create the lower row in FIG. 3 (see Table 2). In the cases in which x, y, and a/b have the same values, the decay time constants at z=0.0005, 0.0010, 0.0500, 0.1000, and 0.150, relative to the decay time constant at z=0 (within the thick solid line rectangle shown in the lower row of FIG. 3) are respectively classified into four levels. For both the level of the light yield and the level of the decay time constant, 1 is better than 0, 2 is better than 1, 3 is better than 2, and 1 is the standard.

[Table 2]

| Ratio [%] of Decay Time Constant to That of Standard | Level |
|---|---|
| 120 ≤ Ratio of Decay Time Constant | 0 |
| 80 ≤ Ratio of Decay Time Constant < 120 | 1 |
| 60 ≤ Ratio of Decay Time Constant < 80 | 2 |
| Ratio of Decay Time Constant < 60 | 3 |

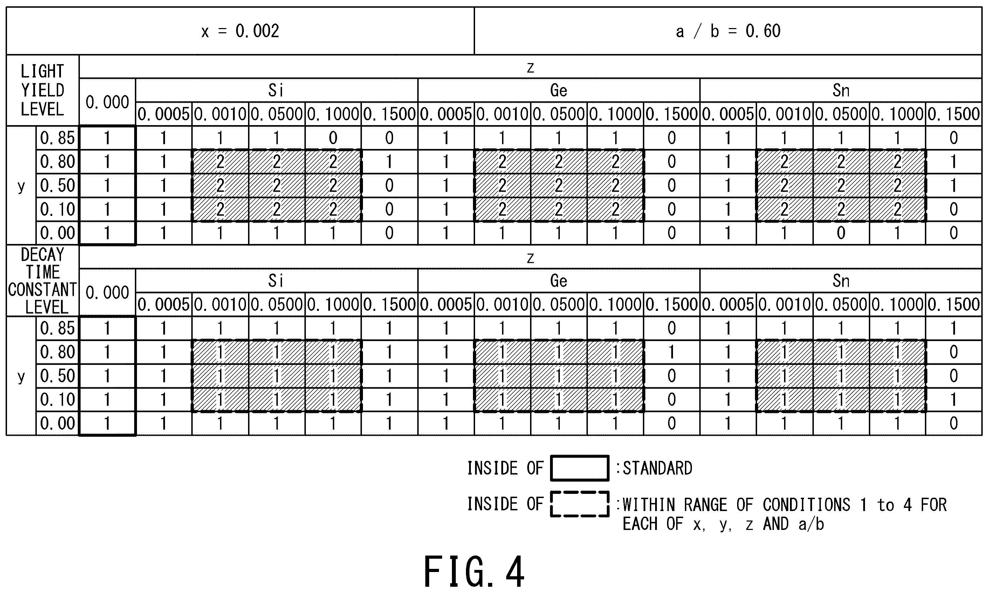

FIG. 4 will be described. FIG. 4 shows levels of the light yield (upper row) and levels of the decay time constant (lower row) when x in the composition is "0.002" which is within the range of the above-described condition 1, and a/b is "0.60" which is within the range of the above-described condition 4. That is to say, the upper row of FIG. 4 shows the levels of the light yield in the case of examples (9×3=27 within the thick broken line rectangle in the upper row) that also satisfy the above-described conditions 2 and 3, and shows the levels of the light yield in the case of comparative examples (53 outside of the thick broken line rectangles in the upper row) that do not satisfy either one of the above-described conditions 2 and 3. The lower row of FIG. 4 similarly shows the levels of the decay time constant in the case of the examples (9×3=27 within the thick broken line rectangle in the lower row) that also satisfy the above-described conditions 2 and 3, and shows the levels of the decay time constant in the case of the comparative examples (53 outside of the thick broken line rectangles in the lower row) that do not satisfy either one of the above-described conditions 2 and 3.

With x fixed to 0.002, and a/b to 0.60, y and z of the above-described conditions 2 and 3 are used as variables to find the light yields [ph/MeV] and the decay time constants [nsec]. The levels of the upper row and the lower row of FIG. 4 are created in the same way as described by using FIG. 3. Since as for the levels, 1 is better than 0, 2 is better than 1, and 3 is better than 2, combinations of x, y, and z with which either one of the level of the light yield and the level of the decay time constant is "2" or more can be said as the compositions with excellent performance, and are the compositions that satisfy the light yield of 10000 [ph/MeV] or more and the decay time constat of 17 [nsec] or less. Ranges of y and z in which the level of either one of the light yield and the decay time constant is "2" or more, that is, preferable ranges are indicated by diagonal line patterns in FIG. 4.

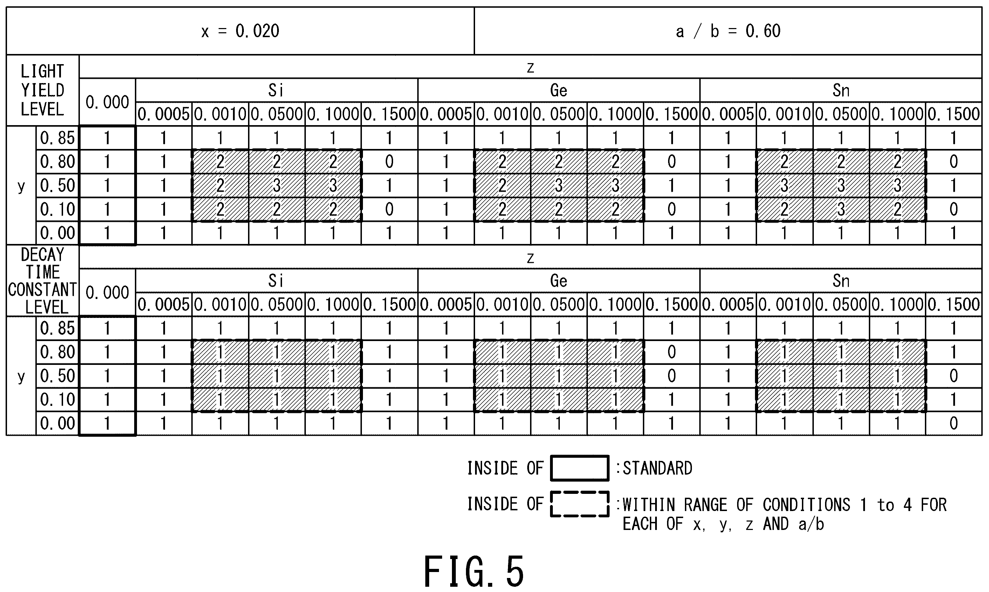

FIG. 5 will be described. FIG. 5 shows the levels of the light yield (upper row), and the levels of the decay time constant (lower row), when x in the composition is "0.020" that is within the range of the above-described condition 1, and a/b is "0.60" that is within the above-described condition 4. That is to say, the upper row of FIG. 5 shows the levels of the light yield in the case of examples (9×3=27 within the thick broken line rectangle in the upper row) that also satisfy the above-described conditions 2 and 3, and shows the levels of the light yield in the case of comparative examples (53 outside of the thick broken line rectangles in the upper row) that do not satisfy either one of the above-described conditions 2 and 3. The lower row of FIG. 5 similarly shows the levels of the decay time constant in the case of the examples (9×3=27 within the thick broken line rectangle in the lower row) that satisfy the above-described conditions 2 and 3, and shows the levels of the decay time constant in the case of the comparative examples (53 outside of the thick broken line rectangles in the lower row) that do not satisfy either one of the above-described conditions 2 and 3.

With x fixed to 0.020, and a/b to 0.60, y and z of the above-described conditions 2 and 3 are used as variables to find the light yields [ph/MeV] and the decay time constants [nsec]. The levels of the upper row and the lower row of FIG. 5 are created in the same way as described by using FIG. 3. Furthermore, ranges of y and z with which the level of either one

# EP 4 703 453 A1

of the light yield and the decay time constant is "2" or more, that is, preferable ranges are indicated by diagonal line patterns in FIG. 5.

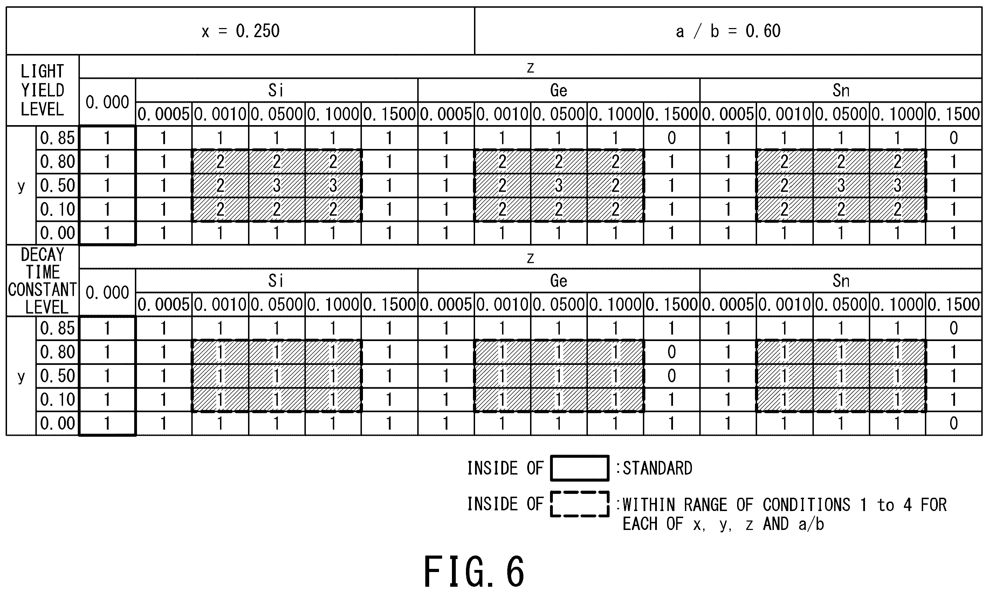

FIG. 6 will be described. FIG. 6 shows the levels of the light yield (upper row), and the level of the decay time constant (lower row), when x in the composition is "0.250" that is within the range of the above-described condition 1, and a/b is "0.60" that is within the range of the above-described condition 4. That is to say, the upper row of FIG. 6 shows the levels of the light yield in the case of examples (9×3=27 within the thick broken line rectangle in the upper row) that also satisfy the above-described conditions 2 and 3, and shows the levels of the light yield in the case of comparative examples (53 outside of the thick broken line rectangles in the upper row) that do not satisfy either one of the above-described conditions 2 and 3. The lower row of FIG. 6 similarly shows the levels of the decay time constant in the case of the examples (9×3=27 within the thick broken line rectangle in the lower row) that also satisfy the above-described conditions 2 and 3, and shows the levels of the decay time constant in the case of the comparative examples (53 outside of the thick broken line rectangles in the lower row) that do not satisfy either one of the above-described conditions 2 and 3.

With x fixed to 0.250, and a/b to 0.60, y and z of the above-described conditions 2 and 3 are used as variables to find the light yields [ph/MeV] and the decay time constants [nsec]. The levels of the upper row and the lower row of FIG. 6 are created in the same way as described by using FIG. 3. Furthermore, ranges of y and Z with which the level of either one of the light yield and the decay time constant is "2" or more, that is, preferable ranges are indicated by diagonal line patterns in FIG. 6.

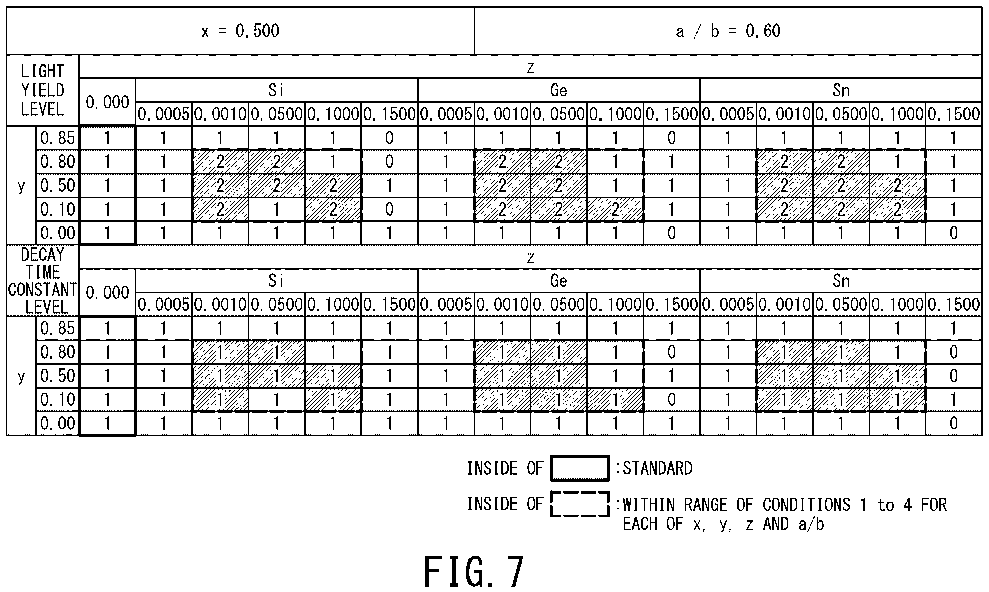

FIG. 7 will be described. FIG. 7 shows the levels of the light yield (upper row), and the levels of the decay time constant (lower row), when x in the composition is "0.500" that is within the range of the above-described condition 1, and a/b is "0.60" that is within the range of the above-described condition 4. That is to say, the upper row of FIG. 7 shows the levels of the light yield in the case of examples (9×3=27 within the thick broken line rectangle in the upper row) that also satisfy the above-described conditions 2 and 3, and shows the levels of the light yield in the case of comparative examples (53 outside of the thick broken line rectangles in the upper row) that do not satisfy either one of the above-described conditions 2 and 3. The lower row of FIG. 7 similarly shows the levels of the decay time constant in the case of the examples (9×3=27 within the thick broken line rectangle in the lower row) that also satisfy the above-described conditions 2 and 3, and shows the levels of the decay time constant in the case of the comparative examples (53 outside of the thick broken line rectangles in the lower row) that do not satisfy either one of the above-described conditions 2 and 3.

With x fixed to 0.500, and a/b to 0.60, y and z of the above-described conditions 2 and 3 are used as variables to find the light yields [ph/MeV] and the decay time constants [nsec]. The levels of the upper row and the lower row of FIG. 7 are created in the same way as described by using FIG. 3. Furthermore, ranges of y and z in which the level of either one of the light yield and the decay time constant is "2" or more, that is, preferable ranges are indicated by diagonal line patterns in FIG. 7.

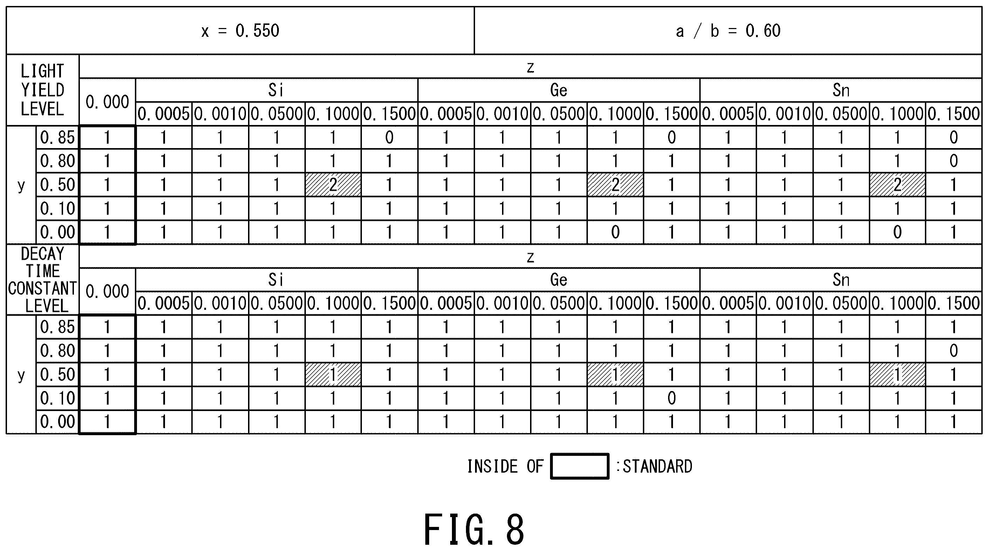

FIG. 8 will be described. FIG. 8 shows the levels of the light yield (upper row) when x in the composition is "0.550" that is outside of the range of the above-described condition 1, and a/b is "0.60" that is within the range of the above-described condition 4, and the levels of the decay time constant (lower row) in the same case. That is to say, the upper row of FIG. 8 shows the levels of the light yield in the case of comparative examples (all of 80 in the upper row), and shows the levels of the decay time constant in the case of the comparative examples (all of 80 in the lower row).

With x fixed to 0.550, and a/b to 0.60, y and z of the above-described conditions 2 and 3 are used as variables to find the light yields [ph/MeV] and the decay time constants [nsec]. The levels of the upper row and the lower row of FIG. 7 are created in the same way as described by using FIG. 3. Furthermore, ranges of y and z with which the level of either one of the light yield and the decay time constant is "2" or more, that is, preferable ranges are indicated by diagonal line patterns in FIG. 8.

Referring to FIG. 3 to FIG. 8, when a/b is 0.60, it is preferable to satisfy the above-described conditions 1 to 3 ($0.002 \leq x \leq 0.500$, $0.1 \leq y \leq 0.8$, $0.001 \leq z \leq 0.100$). By satisfying the above-described conditions 1 to 3 when a/b is 0.6, it is possible to improve the light yield or the decay time constant more than when z=0, and it is possible to improve the light yield to 10000 [ph/MeV] or more, and keep the decay time constant within a preferable range that is 17 [nsec] or less. Note that it is also possible to realize detection with higher precision by the detector when the light yield is 2500 [ph/MeV] or more, and the decay time constant of light emission is less than 10 [nsec], as well as when the light yield of the scintillator is 10000 [ph/MeV] or more, and the decay time constant of light emission is 17 [nsec] or less. Furthermore, as shown in FIG. 8, even if not all of the above-described conditions 1 to 4 are necessarily satisfied, there may be cases where a suitable light yield and decay time constant can be obtained.

Note that in FIG. 3 to FIG. 8, the cases where the type of the metal M related to the variable z is any one of Si, Ge, and Sn are described, but it is not limited to the cases. For example, the metal M may be a combination of two metals (for example, Si and Ge), or a combination of three metals. When the metal M is a combination of Si and Ge, when z=0.050, a total of Si and Ge is controlled to be z=0.050.

8

(Above-described Condition 4, That Is, Variable a/b)

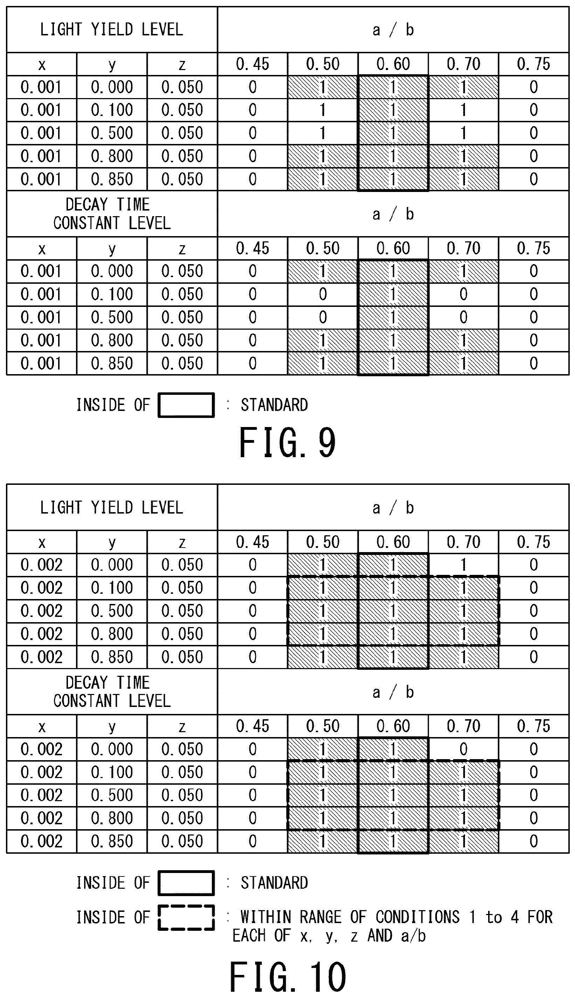

The changes in the light yield and decay time constant according to the variable a/b in the composition of $(Lu_{1-x}Pr_x)_a(Al_{1-y-z}Ga_yM_z)_bO_{1.5(a+b)}$ will be described by using FIG. 9 to FIG. 13.

FIG. 9 will be described. FIG. 9 shows the levels of the light yield (upper row) when x in the composition is "0.001" that is outside of the range of the above-described condition 1, and z is "0050" that is within the range of the above-described condition 3, and the levels (lower row) of the decay time constant in the same case. That is to say, FIG. 9 shows the levels of the light yield in the case of comparative examples (all of 25 in the upper row), and the levels of the decay time constant in the case of the comparative examples (all of 25 in the lower row). Furthermore, the metal M related to the variable z is Si, but may be either one, or a combination of Ge and Sn.

With x fixed to 0.001 and z to 0.050, y and a/b in the above-described conditions 2 and 4 are used as variables to find the light yields [ph/MeV] and decay time constants [nsec]. Then, the ratios [%] of the light yields [ph/MeV] when a/b≈0.60 (for example, a/b=0.45, 0.50, 0.70, and 0.75), to the light yield [ph/MeV] when a/b=0.60 are obtained, and the ratios are classified into levels "0" to "3" in order from a lowest value to create the upper row in FIG. 9 (see Table 1). In the cases in which x, y, and z have the same values, the light yields at a/b=0.45, 0.50, 0.70, and 0.75, relative to the light yield at a/b=0.60 (within the thick solid line rectangle shown in the upper row of FIG. 9) are respectively classified into four levels.

On the other hand, the ratios [%] of the decay time constants [nsec] when a/b≈0.60, to the decay time constant [nsec] when a/b=0.60 are obtained, and the ratios are classified into levels "0" to "3" in order from a highest value to create the lower row in FIG. 9 (see Table 2). In the cases in which x, y, and z have the same values, the decay time constants at a/b=0.45, 0.50, 0.70, and 0.75, relative to the decay time constant at a/b=0.60 (within the thick solid line rectangle shown in the lower row of FIG. 9) are respectively classified into four levels. For both of the levels of the light yield and the levels of the decay time constant, 1 is better than 0, 2 is better than 1, and 3 is better than 2, and 1 is the standard. The ranges of a/b in which the levels of both the light yield and the decay time constant are "1" or more are shown by diagonal line patterns in FIG. 9.

FIG. 10 will be described. FIG. 10 shows the levels of the light yield (upper row), and the levels of the decay time constant (lower row), when x in the composition is "0.002" that is within the range of the above-described condition 1, and z is "0.050" that is within the range of the above-described condition 3. That is to say, the upper row of FIG. 10 shows the levels of the light yield in the case of examples (9 within the thick broken line rectangle in the upper row) that also satisfy the above-described conditions 2 and 4, and shows the levels of the light yield in the case of comparative examples (16 outside of the thick broken line rectangle in the upper row) that do not satisfy either one of the above-described conditions 2 and 4. The lower row of FIG. 10 similarly shows the levels of the decay time constant in the case of the examples (9 within the thick broken line rectangle in the lower row) that also satisfy the above-described conditions 2 and 4, and shows the levels of the decay time constant in the case of the comparative examples (16 outside of the thick broken line rectangle in the lower row) that do not satisfy either one of the above-described conditions 2 and 4.

With x fixed to 0.002, and z to 0.050, y and a/b of the above-described conditions 2 and 4 are used as variables to find the light yields [ph/MeV] and the decay time constants [nsec]. The levels in the upper row and the lower row in FIG. 10 are created in the same way as described by using FIG. 9. Since as for the levels, 1 is better than 0, 2 is better than 1, and 3 is better than 2, a combination of x, y, and a/b with which either one of the level of the light yield and the level of the decay time constant is "1" or more can be said as the composition having excellent performance. The ranges of a/b with which the levels of both the light yield and the decay time constant are "1" or more are shown by the diagonal line patterns in FIG. 10.

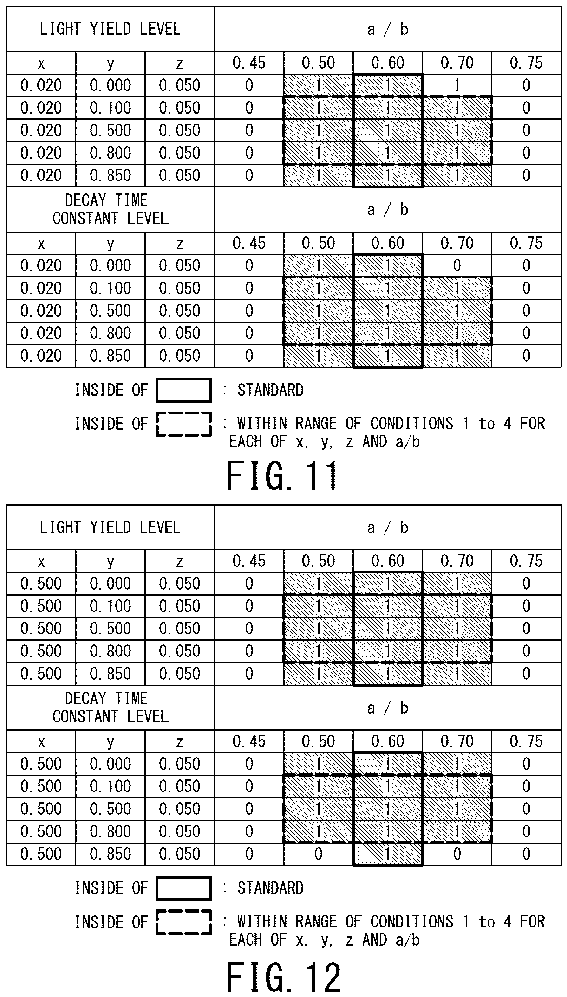

FIG. 11 will be described. FIG. 11 shows the levels of the light yield (upper row) and the levels of the decay time constant (lower row), when x in the composition is "0.020" that is within the range of the above-described condition 1, and z is "0.050" that is within the range of the above-described condition 3. That is to say, the upper row of FIG. 11 shows the levels of the light yield in the case of examples (9 within the thick broken line rectangle in the upper row) that also satisfy the above-described conditions 2 and 4, and shows the levels of the light yield in the case of comparative examples (16 outside of the thick broken line rectangle in the upper row) that do not satisfy either one of the above-described conditions 2 and 4. The lower row of FIG. 11 similarly shows the levels of the decay time constant in the case of the examples (9 within the thick broken line rectangle in the lower row) that also satisfy the above-described conditions 2 and 4, and shows the levels of the decay time constant in the case of the comparative examples (16 outside the thick broken line rectangle in the lower row) that do not satisfy either one of the above-described conditions 2 and 4.

With x fixed to 0.020, and z to 0.050, y and a/b of the above-described conditions 2 and 4 are used as variables to find the light yields [ph/MeV] and the decay time constants [nsec]. The levels in the upper row and the lower row in FIG. 11 are created in the same way as described by using FIG. 9. Furthermore, the ranges of a/b with which the levels of both the light yield and the decay time constant are "1" or more are shown by the diagonal line patterns in FIG. 11.

FIG. 12 will be described. FIG. 12 shows the levels of the light yield (upper row), and the levels of the decay time constant (lower row), when x in the composition is "0.500" that is within the range of the above-described condition 1, and z is "0.050" that is within the range of the above-described condition 3. That is to say, the upper row of FIG. 12 shows the levels of the light yield in the case of examples (9 within the thick broken line rectangle in the upper row) that also satisfy the above-described conditions 2 and 4, and shows the levels of the light yield in the case of comparative examples (16 outside the thick broken line rectangle in the upper row) that do not satisfy either one of the above-described conditions 2 and 4. The lower row of FIG. 12 similarly shows the levels of the decay time constant in the case of the examples (9 within the thick broken line rectangle in the lower row) that also satisfy the above-described conditions 2 and 4, and shows the levels of the decay time constant in the case of the comparative examples (16 outside of the thick broken line rectangle in the lower row) that do not satisfy either one of the above-described conditions 2 and 4.

With x fixed to 0.500, and z to 0.050, y and a/b of the above-described conditions 2 and 4 are used as variables to find the light yield [ph/MeV] and the decay time constant [nsec]. The levels in the upper row and the lower row in FIG. 12 are created in the same way as described by using FIG. 9. Furthermore, the ranges of a/b with which the levels of both the light yield and the decay time constant are "1" or more are shown by the diagonal line patterns in FIG. 12.

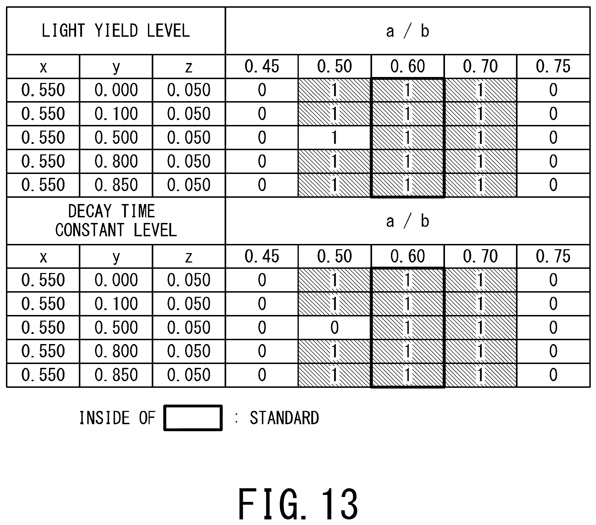

FIG. 13 will be described. FIG. 13 shows the levels of the light yield (upper row) when x in the composition is "0.550" that is outside of the range of the above-described condition 1, and z is "0.050" that is within the range of the above-described condition 3, and the levels of the decay time constant (lower row) in the same case. That is to say, FIG. 13 shows the levels of the light yield in the case of comparative examples (all of 25 in the upper row), and shows the levels of the decay time constant in the case of the comparative examples (all of 25 in the lower row).

With x fixed to 0.550, and z to 0.050, y and a/b of the above-described conditions 2 and 4 are used as variables to find the light yields [ph/MeV] and the decay time constants [nsec]. The levels in the upper row and the lower row in FIG. 13 are created in the same way as described by using FIG. 9. Furthermore, the ranges of a/b with which the levels of both the light yield and the decay time constant are "1" or more are shown by the diagonal line patterns in FIG. 13.

Referring to FIG. 9 to FIG. 13, it can be seen that regardless of x, y, and z, the characteristics deteriorate when a/b deviates from the above-described condition 4. The reason of this deterioration of the characteristics is that other substances (heterogeneous phases) are mixed into the garnet phase (a/b=0.6). When a/b is large, a perovskite phase (a/b=1.0) is formed, and when a/b is small, oxides of Al, Ga, and M elements (a/b=0) will remain. These heterogeneous phases cause a deterioration in characteristics, such as a decrease in light yield and a longer decay time constant. The occurrence of the heterogeneous phase is generally independent of x, y, and z and is determined only by a/b, and therefore the results are consistent with the experimental data. Furthermore, it can be easily inferred that this also applies to the values other than the values of x, y, and z listed in the tables.

If the variables x, y, z, a and b in the composition represented by $(Lu_{1-x}Pr_x)_a(Al_{1-y-z}Ga_yM_z)_bO_{1.5(a+b)}$ are in the above described ranges, it is possible to provide a fluorescent material with a small decay time constant of light emission. By applying the fluorescent material as a ceramic scintillator of an X-ray detector for a medical application, it is also possible to handle with required reactivity.

According to at least one embodiment described above, it is possible to provide a ceramic scintillator that can handle with a high counting rate, a photon-counting type X-ray detector equipped with it, and a method for manufacturing the ceramic scintillator.

The ceramic scintillator 11 is not limited to the case of being applied to a photon-counting type X-ray detector equipped with a silicon photomultiplier, in X-ray CT equipment. For example, the ceramic scintillator 11 may be applied to an X-ray detector equipped with photodiode, in X-ray CT equipment. The ceramic scintillator 11 may also be applied to a flat panel detector (FPD: Flat Panel Detector) equipped with CMOS (Complementary Metal Oxide Semiconductor). The ceramic scintillator 11 may be applied to a photon-counting type detector equipped with a silicon photomultiplier, in PET (Positron Emission Tomography) equipment. The ceramic scintillator 11 may be applied to imaging for industrial applications such as baggage inspection, and a nondestructive inspection.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

**Claims**

1. A ceramic scintillator comprising: a garnet compound having a composition represented by

$$(Lu_{1-x}Pr_x)_a(Al_{1-y-z}Ga_yM_z)_bO_{1.5\{a+b\}},$$

wherein M in the composition includes one kind or more of Si, Ge, and Sn, and x, y, and z respectively satisfy

$$0.002 \leq x \leq 0.500,$$

$$0.1 \leq y \leq 0.8,$$

and

$$0.0010 \leq z \leq 0.1000.$$

2. The ceramic scintillator according to claim 1, wherein a and b in the composition satisfy

$$0.50 \leq a/b \leq 0.70.$$

3. The ceramic scintillator according to claim 1, wherein a decay time constant of light emission is less than 10 [nsec], and a light yield is 2500 [ph/MeV] or more.

4. The ceramic scintillator according to claim 1, wherein a decay time constant of light emission is 17 [nsec] or less, and a light yield is 10000 [ph/MeV] or more.

5. A photon-counting type X-ray detector, comprising:

the ceramic scintillator according to any one of claims 1 to 4; and
a silicon photomultiplier.

6. A method for manufacturing the ceramic scintillator according to any one of claims 1 to 4, comprising:

a first step of filling an alumina container with a mixture of oxide powders of Lu, Pr, Al, Ga and M in the composition and mixing the mixture;
a second step of firing the mixed mixture at a temperature of 1300°C or higher;
a third step of filling an alumina container with a product obtained by the second step, and firing the product at a temperature of 1200°C or higher in a nitrogen/hydrogen mixed atmosphere;
a fourth step of molding a product obtained by the third step; and
a fifth step of sintering a product obtained by the fourth step to manufacture the ceramic scintillator.

FIG. 1

FIG. 2

| | x = 0.001 | | | | | | a / b = 0.60 | | | | | | | | | |
|---|---|---|---|---|---|---|---|---|---|---|---|---|---|---|---|---|---|
| LIGHT YIELD LEVEL | | z | | | | | | | | | | | | | | | |
| | 0.000 | Si | | | | | | Ge | | | | | Sn | | | | |
| | | 0.0005 | 0.0010 | 0.0500 | 0.1000 | 0.1500 | 0.0005 | 0.0010 | 0.0500 | 0.1000 | 0.1500 | 0.0005 | 0.0010 | 0.0500 | 0.1000 | 0.1500 |
| y 0.85 | 1 | 1 | 1 | 1 | 0 | 0 | 1 | 1 | 1 | 0 | 0 | 1 | 1 | 1 | 0 | 0 |
| 0.80 | 1 | 1 | 1 | 1 | 0 | 0 | 1 | 1 | 1 | 1 | 0 | 1 | 1 | 1 | 1 | 0 |
| 0.50 | 1 | 1 | 1 | 1 | 1 | 0 | 1 | 1 | 1 | 1 | 0 | 1 | 1 | 1 | 1 | 0 |
| 0.10 | 1 | 1 | 1 | 1 | 1 | 0 | 1 | 1 | 1 | 0 | 0 | 1 | 1 | 1 | 1 | 0 |
| 0.00 | 1 | 1 | 1 | 1 | 1 | 0 | 1 | 1 | 1 | 1 | 0 | 1 | 1 | 0 | 1 | 0 |
| DECAY TIME CONSTANT LEVEL | | z | | | | | | | | | | | | | | | |
| | 0.000 | Si | | | | | | Ge | | | | | Sn | | | | |
| | | 0.0005 | 0.0010 | 0.0500 | 0.1000 | 0.1500 | 0.0005 | 0.0010 | 0.0500 | 0.1000 | 0.1500 | 0.0005 | 0.0010 | 0.0500 | 0.1000 | 0.1500 |
| y 0.85 | 1 | 1 | 1 | 1 | 1 | 1 | 1 | 1 | 1 | 1 | 0 | 1 | 1 | 1 | 1 | 1 |
| 0.80 | 1 | 1 | 1 | 1 | 1 | 1 | 1 | 1 | 1 | 0 | 1 | 1 | 1 | 0 | 1 | 0 |
| 0.50 | 1 | 1 | 1 | 1 | 1 | 1 | 1 | 1 | 0 | 0 | 0 | 1 | 0 | 1 | 0 | 0 |
| 0.10 | 1 | 1 | 1 | 1 | 1 | 1 | 1 | 1 | 1 | 1 | 0 | 1 | 1 | 0 | 0 | 0 |
| 0.00 | 1 | 1 | 1 | 1 | 1 | 1 | 1 | 1 | 1 | 1 | 1 | 1 | 1 | 1 | 1 | 1 |

INSIDE OF ☐ :STANDARD

FIG. 3

EP 4 703 453 A1

| x = 0.002 | | | | | | a / b = 0.60 | | | | | | | | | |
|---|---|---|---|---|---|---|---|---|---|---|---|---|---|---|---|

**LIGHT YIELD LEVEL**

| | | 0.000 | z | | | | | | | | | | | | | |
|---|---|---|---|---|---|---|---|---|---|---|---|---|---|---|---|---|
| | | | Si | | | | | Ge | | | | | Sn | | | | |
| | | | 0.0005 | 0.0010 | 0.0500 | 0.1000 | 0.1500 | 0.0005 | 0.0010 | 0.0500 | 0.1000 | 0.1500 | 0.0005 | 0.0010 | 0.0500 | 0.1000 | 0.1500 |
| | 0.85 | 1 | 1 | 1 | 1 | 0 | 0 | 1 | 1 | 1 | 1 | 0 | 1 | 1 | 1 | 1 | 0 |
| | 0.80 | 1 | 1 | 2 | 2 | 2 | 1 | 1 | 2 | 2 | 2 | 0 | 1 | 2 | 2 | 2 | 1 |
| y | 0.50 | 1 | 1 | 2 | 2 | 2 | 0 | 1 | 2 | 2 | 2 | 0 | 1 | 2 | 2 | 2 | 1 |
| | 0.10 | 1 | 1 | 2 | 2 | 2 | 0 | 1 | 2 | 2 | 2 | 0 | 1 | 2 | 2 | 2 | 0 |
| | 0.00 | 1 | 1 | 1 | 1 | 1 | 0 | 1 | 1 | 1 | 1 | 0 | 1 | 1 | 0 | 1 | 0 |

**DECAY TIME CONSTANT LEVEL**

| | | 0.000 | z | | | | | | | | | | | | | |
|---|---|---|---|---|---|---|---|---|---|---|---|---|---|---|---|---|---|
| | | | Si | | | | | Ge | | | | | Sn | | | | |
| | | | 0.0005 | 0.0010 | 0.0500 | 0.1000 | 0.1500 | 0.0005 | 0.0010 | 0.0500 | 0.1000 | 0.1500 | 0.0005 | 0.0010 | 0.0500 | 0.1000 | 0.1500 |
| | 0.85 | 1 | 1 | 1 | 1 | 1 | 1 | 1 | 1 | 1 | 1 | 0 | 1 | 1 | 1 | 1 | 1 |
| | 0.80 | 1 | 1 | 1 | 1 | 1 | 1 | 1 | 1 | 1 | 1 | 1 | 1 | 1 | 1 | 1 | 0 |
| y | 0.50 | 1 | 1 | 1 | 1 | 1 | 1 | 1 | 1 | 1 | 1 | 0 | 1 | 1 | 1 | 1 | 0 |
| | 0.10 | 1 | 1 | 1 | 1 | 1 | 1 | 1 | 1 | 1 | 1 | 0 | 1 | 1 | 1 | 1 | 1 |
| | 0.00 | 1 | 1 | 1 | 1 | 1 | 1 | 1 | 1 | 1 | 1 | 0 | 1 | 1 | 1 | 1 | 0 |

INSIDE OF [  ] : STANDARD

INSIDE OF [- - -] : WITHIN RANGE OF CONDITIONS 1 to 4 FOR EACH OF x, y, z AND a/b

FIG. 4

| | | | z | | | | | | | | | | | | | |
|---|---|---|---|---|---|---|---|---|---|---|---|---|---|---|---|---|
| LIGHT YIELD LEVEL | | 0.000 | Si | | | | | Ge | | | | | Sn | | | |
| | | | 0.0005 | 0.0010 | 0.0500 | 0.1000 | 0.1500 | 0.0005 | 0.0010 | 0.0500 | 0.1000 | 0.1500 | 0.0005 | 0.0010 | 0.0500 | 0.1000 | 0.1500 |
| | 0.85 | 1 | 1 | 1 | 1 | 1 | 1 | 1 | 1 | 1 | 1 | 1 | 1 | 1 | 1 | 1 | 1 |
| | 0.80 | 1 | 1 | 2 | 2 | 2 | 0 | 1 | 2 | 2 | 2 | 0 | 1 | 2 | 2 | 2 | 0 |
| y | 0.50 | 1 | 1 | 2 | 3 | 3 | 1 | 1 | 2 | 3 | 3 | 1 | 1 | 3 | 3 | 3 | 1 |
| | 0.10 | 1 | 1 | 2 | 2 | 2 | 0 | 1 | 2 | 2 | 2 | 0 | 1 | 2 | 3 | 2 | 0 |
| | 0.00 | 1 | 1 | 1 | 1 | 1 | 1 | 1 | 1 | 1 | 1 | 1 | 1 | 1 | 1 | 1 | 1 |

| | | | z | | | | | | | | | | | | | |
|---|---|---|---|---|---|---|---|---|---|---|---|---|---|---|---|---|---|
| DECAY TIME CONSTANT LEVEL | | 0.000 | Si | | | | | Ge | | | | | Sn | | | |
| | | | 0.0005 | 0.0010 | 0.0500 | 0.1000 | 0.1500 | 0.0005 | 0.0010 | 0.0500 | 0.1000 | 0.1500 | 0.0005 | 0.0010 | 0.0500 | 0.1000 | 0.1500 |
| | 0.85 | 1 | 1 | 1 | 1 | 1 | 1 | 1 | 1 | 1 | 1 | 1 | 1 | 1 | 1 | 1 | 1 |
| | 0.80 | 1 | 1 | 1 | 1 | 1 | 1 | 1 | 1 | 1 | 1 | 0 | 1 | 1 | 1 | 1 | 1 |
| y | 0.50 | 1 | 1 | 1 | 1 | 1 | 1 | 1 | 1 | 1 | 1 | 0 | 1 | 1 | 1 | 1 | 0 |
| | 0.10 | 1 | 1 | 1 | 1 | 1 | 1 | 1 | 1 | 1 | 1 | 1 | 1 | 1 | 1 | 1 | 1 |
| | 0.00 | 1 | 1 | 1 | 1 | 1 | 1 | 1 | 1 | 1 | 1 | 1 | 1 | 1 | 1 | 1 | 0 |

INSIDE OF ☐ : STANDARD

INSIDE OF ⌐ ¬ : WITHIN RANGE OF CONDITIONS 1 to 4 FOR EACH OF x, y, z AND a/b

FIG. 5

| x = 0.250 | | | | | | a / b = 0.60 | | | | | | | | | |
|---|---|---|---|---|---|---|---|---|---|---|---|---|---|---|---|
| **LIGHT YIELD LEVEL** | | z | | | | | | | | | | | | | |
| | 0.000 | Si | | | | | Ge | | | | | Sn | | | | |

| LIGHT YIELD LEVEL | 0.000 | \(z\) Si 0.0005 | 0.0010 | 0.0500 | 0.1000 | 0.1500 | Ge 0.0005 | 0.0010 | 0.0500 | 0.1000 | 0.1500 | Sn 0.0005 | 0.0010 | 0.0500 | 0.1000 | 0.1500 |
|---|---|---|---|---|---|---|---|---|---|---|---|---|---|---|---|---|
| y 0.85 | 1 | 1 | 1 | 1 | 1 | 1 | 1 | 1 | 1 | 1 | 0 | 1 | 1 | 1 | 1 | 0 |
| y 0.80 | 1 | 1 | 2 | 2 | 2 | 1 | 1 | 2 | 2 | 2 | 1 | 1 | 2 | 2 | 2 | 1 |
| y 0.50 | 1 | 1 | 2 | 3 | 3 | 1 | 1 | 2 | 3 | 2 | 1 | 1 | 2 | 3 | 3 | 1 |
| y 0.10 | 1 | 1 | 2 | 2 | 2 | 1 | 1 | 2 | 2 | 2 | 1 | 1 | 2 | 2 | 2 | 1 |
| y 0.00 | 1 | 1 | 1 | 1 | 1 | 1 | 1 | 1 | 1 | 1 | 1 | 1 | 1 | 1 | 1 | 1 |

| DECAY TIME CONSTANT LEVEL | 0.000 | \(z\) Si 0.0005 | 0.0010 | 0.0500 | 0.1000 | 0.1500 | Ge 0.0005 | 0.0010 | 0.0500 | 0.1000 | 0.1500 | Sn 0.0005 | 0.0010 | 0.0500 | 0.1000 | 0.1500 |
|---|---|---|---|---|---|---|---|---|---|---|---|---|---|---|---|---|
| y 0.85 | 1 | 1 | 1 | 1 | 1 | 1 | 1 | 1 | 1 | 1 | 1 | 1 | 1 | 1 | 1 | 0 |
| y 0.80 | 1 | 1 | 1 | 1 | 1 | 1 | 1 | 1 | 1 | 1 | 0 | 1 | 1 | 1 | 1 | 1 |
| y 0.50 | 1 | 1 | 1 | 1 | 1 | 1 | 1 | 1 | 1 | 1 | 0 | 1 | 1 | 1 | 1 | 1 |
| y 0.10 | 1 | 1 | 1 | 1 | 1 | 1 | 1 | 1 | 1 | 1 | 1 | 1 | 1 | 1 | 1 | 1 |
| y 0.00 | 1 | 1 | 1 | 1 | 1 | 1 | 1 | 1 | 1 | 1 | 1 | 1 | 1 | 1 | 1 | 0 |

INSIDE OF [  ] : STANDARD

INSIDE OF [- - -] : WITHIN RANGE OF CONDITIONS 1 to 4 FOR EACH OF x, y, z AND a/b

## FIG. 6

EP 4 703 453 A1

| x = 0.500 | | | | | | a / b = 0.60 | | | | | | | | | |

**LIGHT YIELD LEVEL**

| | | | z | | | | | | | | | | | | | |
| LIGHT YIELD LEVEL | | 0.000 | Si | | | | | Ge | | | | | Sn | | | | |
| | | | 0.0005 | 0.0010 | 0.0500 | 0.1000 | 0.1500 | 0.0005 | 0.0010 | 0.0500 | 0.1000 | 0.1500 | 0.0005 | 0.0010 | 0.0500 | 0.1000 | 0.1500 |
|---|---|---|---|---|---|---|---|---|---|---|---|---|---|---|---|---|---|
| | 0.85 | 1 | 1 | 1 | 1 | 1 | 0 | 1 | 1 | 1 | 1 | 0 | 1 | 1 | 1 | 1 | 1 |
| | 0.80 | 1 | 1 | 2 | 2 | 1 | 0 | 1 | 2 | 2 | 1 | 1 | 1 | 2 | 2 | 1 | 1 |
| y | 0.50 | 1 | 1 | 2 | 2 | 2 | 1 | 1 | 2 | 2 | 1 | 1 | 1 | 2 | 2 | 2 | 1 |
| | 0.10 | 1 | 1 | 2 | 1 | 2 | 0 | 1 | 2 | 2 | 2 | 1 | 1 | 2 | 2 | 2 | 1 |
| | 0.00 | 1 | 1 | 1 | 1 | 1 | 1 | 1 | 1 | 1 | 1 | 0 | 1 | 1 | 1 | 1 | 0 |

**DECAY TIME CONSTANT LEVEL**

| | | | z | | | | | | | | | | | | | |
| DECAY TIME CONSTANT LEVEL | | 0.000 | Si | | | | | Ge | | | | | Sn | | | | |
| | | | 0.0005 | 0.0010 | 0.0500 | 0.1000 | 0.1500 | 0.0005 | 0.0010 | 0.0500 | 0.1000 | 0.1500 | 0.0005 | 0.0010 | 0.0500 | 0.1000 | 0.1500 |
|---|---|---|---|---|---|---|---|---|---|---|---|---|---|---|---|---|---|
| | 0.85 | 1 | 1 | 1 | 1 | 1 | 1 | 1 | 1 | 1 | 1 | 1 | 1 | 1 | 1 | 1 | 1 |
| | 0.80 | 1 | 1 | 1 | 1 | 1 | 1 | 1 | 1 | 1 | 1 | 0 | 1 | 1 | 1 | 1 | 0 |
| y | 0.50 | 1 | 1 | 1 | 1 | 1 | 1 | 1 | 1 | 1 | 1 | 1 | 1 | 1 | 1 | 1 | 0 |
| | 0.10 | 1 | 1 | 1 | 1 | 1 | 1 | 1 | 1 | 1 | 1 | 0 | 1 | 1 | 1 | 1 | 1 |
| | 0.00 | 1 | 1 | 1 | 1 | 1 | 1 | 1 | 1 | 1 | 1 | 1 | 1 | 1 | 1 | 1 | 0 |

INSIDE OF ☐ : STANDARD

INSIDE OF ⌐ ⌐ : WITHIN RANGE OF CONDITIONS 1 to 4 FOR EACH OF x, y, z AND a/b

**FIG. 7**

| | | x = 0.550 | | | | | a / b = 0.60 | | | | | | | | | |
|---|---|---|---|---|---|---|---|---|---|---|---|---|---|---|---|---|
| **LIGHT YIELD LEVEL** | | 0.000 | z | | | | | | | | | | | | | |
| | | | Si | | | | | Ge | | | | | Sn | | | | |
| | | | 0.0005 | 0.0010 | 0.0500 | 0.1000 | 0.1500 | 0.0005 | 0.0010 | 0.0500 | 0.1000 | 0.1500 | 0.0005 | 0.0010 | 0.0500 | 0.1000 | 0.1500 |
| y | 0.85 | 1 | 1 | 1 | 1 | 1 | 0 | 1 | 1 | 1 | 1 | 0 | 1 | 1 | 1 | 1 | 0 |
| | 0.80 | 1 | 1 | 1 | 1 | 1 | 1 | 1 | 1 | 1 | 1 | 1 | 1 | 1 | 1 | 1 | 0 |
| | 0.50 | 1 | 1 | 1 | 1 | 2 | 1 | 1 | 1 | 1 | 2 | 1 | 1 | 1 | 1 | 2 | 1 |
| | 0.10 | 1 | 1 | 1 | 1 | 1 | 1 | 1 | 1 | 1 | 1 | 1 | 1 | 1 | 1 | 1 | 1 |
| | 0.00 | 1 | 1 | 1 | 1 | 1 | 1 | 1 | 1 | 1 | 0 | 1 | 1 | 1 | 1 | 0 | 1 |
| **DECAY TIME CONSTANT LEVEL** | | 0.000 | z | | | | | | | | | | | | | |
| | | | Si | | | | | Ge | | | | | Sn | | | | |
| | | | 0.0005 | 0.0010 | 0.0500 | 0.1000 | 0.1500 | 0.0005 | 0.0010 | 0.0500 | 0.1000 | 0.1500 | 0.0005 | 0.0010 | 0.0500 | 0.1000 | 0.1500 |
| y | 0.85 | 1 | 1 | 1 | 1 | 1 | 1 | 1 | 1 | 1 | 1 | 1 | 1 | 1 | 1 | 1 | 1 |
| | 0.80 | 1 | 1 | 1 | 1 | 1 | 1 | 1 | 1 | 1 | 1 | 1 | 1 | 1 | 1 | 1 | 0 |
| | 0.50 | 1 | 1 | 1 | 1 | 1 | 1 | 1 | 1 | 1 | 1 | 1 | 1 | 1 | 1 | 1 | 1 |
| | 0.10 | 1 | 1 | 1 | 1 | 1 | 1 | 1 | 1 | 1 | 1 | 0 | 1 | 1 | 1 | 1 | 1 |
| | 0.00 | 1 | 1 | 1 | 1 | 1 | 1 | 1 | 1 | 1 | 1 | 1 | 1 | 1 | 1 | 1 | 1 |

INSIDE OF ☐ : STANDARD

FIG. 8

| LIGHT YIELD LEVEL | | | a / b | | | | |
|---|---|---|---|---|---|---|---|
| x | y | z | 0.45 | 0.50 | 0.60 | 0.70 | 0.75 |
| 0.001 | 0.000 | 0.050 | 0 | 1 | 1 | 1 | 0 |
| 0.001 | 0.100 | 0.050 | 0 | 1 | 1 | 1 | 0 |
| 0.001 | 0.500 | 0.050 | 0 | 1 | 1 | 1 | 0 |
| 0.001 | 0.800 | 0.050 | 0 | 1 | 1 | 1 | 0 |
| 0.001 | 0.850 | 0.050 | 0 | 1 | 1 | 1 | 0 |
| DECAY TIME CONSTANT LEVEL | | | a / b | | | | |
| x | y | z | 0.45 | 0.50 | 0.60 | 0.70 | 0.75 |
| 0.001 | 0.000 | 0.050 | 0 | 1 | 1 | 1 | 0 |
| 0.001 | 0.100 | 0.050 | 0 | 0 | 1 | 0 | 0 |
| 0.001 | 0.500 | 0.050 | 0 | 0 | 1 | 0 | 0 |
| 0.001 | 0.800 | 0.050 | 0 | 1 | 1 | 1 | 0 |
| 0.001 | 0.850 | 0.050 | 0 | 1 | 1 | 1 | 0 |

INSIDE OF [ ] : STANDARD

# FIG. 9

| LIGHT YIELD LEVEL | | | a / b | | | | |
|---|---|---|---|---|---|---|---|
| x | y | z | 0.45 | 0.50 | 0.60 | 0.70 | 0.75 |
| 0.002 | 0.000 | 0.050 | 0 | 1 | 1 | 1 | 0 |
| 0.002 | 0.100 | 0.050 | 0 | 1 | 1 | 1 | 0 |
| 0.002 | 0.500 | 0.050 | 0 | 1 | 1 | 1 | 0 |
| 0.002 | 0.800 | 0.050 | 0 | 1 | 1 | 1 | 0 |
| 0.002 | 0.850 | 0.050 | 0 | 1 | 1 | 1 | 0 |
| DECAY TIME CONSTANT LEVEL | | | a / b | | | | |
| x | y | z | 0.45 | 0.50 | 0.60 | 0.70 | 0.75 |
| 0.002 | 0.000 | 0.050 | 0 | 1 | 1 | 0 | 0 |
| 0.002 | 0.100 | 0.050 | 0 | 1 | 1 | 1 | 0 |
| 0.002 | 0.500 | 0.050 | 0 | 1 | 1 | 1 | 0 |
| 0.002 | 0.800 | 0.050 | 0 | 1 | 1 | 1 | 0 |
| 0.002 | 0.850 | 0.050 | 0 | 1 | 1 | 1 | 0 |

INSIDE OF [ ] : STANDARD

INSIDE OF [ ] : WITHIN RANGE OF CONDITIONS 1 to 4 FOR EACH OF x, y, z AND a/b

# FIG. 10

| LIGHT YIELD LEVEL | | | a / b | | | | |
|---|---|---|---|---|---|---|---|
| x | y | z | 0.45 | 0.50 | 0.60 | 0.70 | 0.75 |
| 0.020 | 0.000 | 0.050 | 0 | 1 | 1 | 1 | 0 |
| 0.020 | 0.100 | 0.050 | 0 | 1 | 1 | 1 | 0 |
| 0.020 | 0.500 | 0.050 | 0 | 1 | 1 | 1 | 0 |
| 0.020 | 0.800 | 0.050 | 0 | 1 | 1 | 1 | 0 |
| 0.020 | 0.850 | 0.050 | 0 | 1 | 1 | 1 | 0 |
| DECAY TIME CONSTANT LEVEL | | | a / b | | | | |
| x | y | z | 0.45 | 0.50 | 0.60 | 0.70 | 0.75 |
| 0.020 | 0.000 | 0.050 | 0 | 1 | 1 | 0 | 0 |
| 0.020 | 0.100 | 0.050 | 0 | 1 | 1 | 1 | 0 |
| 0.020 | 0.500 | 0.050 | 0 | 1 | 1 | 1 | 0 |
| 0.020 | 0.800 | 0.050 | 0 | 1 | 1 | 1 | 0 |
| 0.020 | 0.850 | 0.050 | 0 | 1 | 1 | 1 | 0 |

INSIDE OF ☐ : STANDARD

INSIDE OF ⬚ : WITHIN RANGE OF CONDITIONS 1 to 4 FOR EACH OF x, y, z AND a/b

# FIG. 11

| LIGHT YIELD LEVEL | | | a / b | | | | |
|---|---|---|---|---|---|---|---|
| x | y | z | 0.45 | 0.50 | 0.60 | 0.70 | 0.75 |
| 0.500 | 0.000 | 0.050 | 0 | 1 | 1 | 1 | 0 |
| 0.500 | 0.100 | 0.050 | 0 | 1 | 1 | 1 | 0 |
| 0.500 | 0.500 | 0.050 | 0 | 1 | 1 | 1 | 0 |
| 0.500 | 0.800 | 0.050 | 0 | 1 | 1 | 1 | 0 |
| 0.500 | 0.850 | 0.050 | 0 | 1 | 1 | 1 | 0 |
| DECAY TIME CONSTANT LEVEL | | | a / b | | | | |
| x | y | z | 0.45 | 0.50 | 0.60 | 0.70 | 0.75 |
| 0.500 | 0.000 | 0.050 | 0 | 1 | 1 | 1 | 0 |
| 0.500 | 0.100 | 0.050 | 0 | 1 | 1 | 1 | 0 |
| 0.500 | 0.500 | 0.050 | 0 | 1 | 1 | 1 | 0 |
| 0.500 | 0.800 | 0.050 | 0 | 1 | 1 | 1 | 0 |
| 0.500 | 0.850 | 0.050 | 0 | 0 | 1 | 0 | 0 |

INSIDE OF ☐ : STANDARD

INSIDE OF ⬚ : WITHIN RANGE OF CONDITIONS 1 to 4 FOR EACH OF x, y, z AND a/b

# FIG. 12

| LIGHT YIELD LEVEL | | | a / b | | | | |
|---|---|---|---|---|---|---|---|
| x | y | z | 0.45 | 0.50 | 0.60 | 0.70 | 0.75 |
| 0.550 | 0.000 | 0.050 | 0 | 1 | 1 | 1 | 0 |
| 0.550 | 0.100 | 0.050 | 0 | 1 | 1 | 1 | 0 |
| 0.550 | 0.500 | 0.050 | 0 | 1 | 1 | 1 | 0 |
| 0.550 | 0.800 | 0.050 | 0 | 1 | 1 | 1 | 0 |
| 0.550 | 0.850 | 0.050 | 0 | 1 | 1 | 1 | 0 |
| DECAY TIME CONSTANT LEVEL | | | a / b | | | | |
| x | y | z | 0.45 | 0.50 | 0.60 | 0.70 | 0.75 |
| 0.550 | 0.000 | 0.050 | 0 | 1 | 1 | 1 | 0 |
| 0.550 | 0.100 | 0.050 | 0 | 1 | 1 | 1 | 0 |
| 0.550 | 0.500 | 0.050 | 0 | 0 | 1 | 1 | 0 |
| 0.550 | 0.800 | 0.050 | 0 | 1 | 1 | 1 | 0 |
| 0.550 | 0.850 | 0.050 | 0 | 1 | 1 | 1 | 0 |

INSIDE OF ▭ : STANDARD

# FIG. 13

## INTERNATIONAL SEARCH REPORT

| | International application No. |
|---|---|
| | **PCT/JP2024/015835** |

**A. CLASSIFICATION OF SUBJECT MATTER**

*C09K 11/80*(2006.01)i; *C09K 11/00*(2006.01)i; *C09K 11/08*(2006.01)i; *G01T 1/20*(2006.01)i
FI:   C09K11/80; G01T1/20 B; C09K11/00 E; C09K11/08 B

According to International Patent Classification (IPC) or to both national classification and IPC

**B. FIELDS SEARCHED**

Minimum documentation searched (classification system followed by classification symbols)

C09K11/00-11/89; G01T1/20

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| Y | WO 2022/050417 A1 (TOSHIBA MATERIALS CO., LTD.) 10 March 2022 (2022-03-10) claims 1, 6, paragraphs [0033]-[0054], tables 2-5, fig. 3, 4, examples 1-52 | 1, 3-6 |
| A | entire text, all drawings | 2 |
| Y | JP 2010-235388 A (WORLD LAB K.K.) 21 October 2010 (2010-10-21) claim 1, paragraphs [0028], [0036], [0046], [0059], [0080]-[0126], tables 1-23, examples | 1, 3-6 |
| A | WO 2022/218663 A1 (EVONIK OPERATIONS GMBH) 20 October 2022 (2022-10-20) entire text, all drawings | 1-6 |
| A | CN 112980444 A (CHANGCHUN INSTITUTE OF APPLIED CHEMISTRY, CHINESE ACADEMY OF SCIENCES) 18 June 2021 (2021-06-18) entire text, all drawings | 1-6 |
| A | JP 2021-165368 A (EVONIK OPERATIONS GMBH) 14 October 2021 (2021-10-14) entire text, all drawings | 1-6 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **13 June 2024** | **02 July 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/015835**

| Patent document cited in search report | | | Publication date (day/month/year) | Patent family member(s) | | | Publication date (day/month/year) |
|---|---|---|---|---|---|---|---|
| WO | 2022/050417 | A1 | 10 March 2022 | US 2023/0204802 A1 claims 1, 6, paragraphs [0035]-[0052], tables 2-5, fig. 3, 4, examples 1-52 | | | |
| JP | 2010-235388 | A | 21 October 2010 | (Family: none) | | | |
| WO | 2022/218663 | A1 | 20 October 2022 | CN 117203306 A | | | |
| CN | 112980444 | A | 18 June 2021 | (Family: none) | | | |
| JP | 2021-165368 | A | 14 October 2021 | US 2021/0253889 A1 entire text, all drawings | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018002974 A

- JP 2010235388 A